# FASCICULE DE BREVET EUROPEEN

(11) **EP 2 936 637 B1**
(45) Date de publication et mention de la délivrance du brevet: **14.04.2021**
(21) Numéro de dépôt: 13821872.2
(22) Date de dépôt: 17.12.2013
(51) Int. Cl.: H02G 3/12, H02G 3/18

(54) **MODULE D'APPAREILLAGE ELECTRIQUE AMOVIBLE, BOITE ELECTRIQUE D'ACCUEIL D'UN TEL MODULE D'APPAREILLAGE ET PROCEDE DE REMPLACEMENT D'UN TEL MODULE D'APPAREILLAGE**
ABNEHMBARES MODUL FÜR EINE ELEKTRISCHE AUSRÜSTUNG, VERDRAHTUNGSDOSE ZUR AUFNAHME SOLCH EINES AUSRÜSTUNGSMODULS UND VERFAHREN ZUM AUSTAUSCHEN SOLCH EINES AUSRÜSTUNGSMODULS
REMOVABLE ELECTRICAL EQUIPMENT MODULE, WIRING BOX FOR RECEIVING SUCH AN EQUIPMENT MODULE AND METHOD FOR REPLACING SUCH AN EQUIPMENT MODULE

(30) Priorité: 20.12.2012 FR 1203507
(43) Date de publication de la demande: 28.10.2015
(73) Titulaire: Legrand France, 87000 Limoges (FR); Legrand SNC, 87000 Limoges (FR)
(72) Inventeur: CAILLE, Jean-Loup, F-87510 Peyrilhac (FR); MAZIERE, Laurent, F-87220 Feytiat (FR)
(74) Mandataire: Jacobacci Coralis Harle
(86) Numéro de dépôt international: PCT/FR2013/053128
(87) Numéro de publication internationale: WO 2014/096679

(56) Documents cités:
- EP-A2- 2 200 416
- DE-A1- 10 020 216
- DE-U- 7 030 837
- DE-U1- 9 000 234
- DE-U1- 9 106 123
- US-A- 2 934 590

## Description

### DOMAINE TECHNIQUE AUQUEL SE RAPPORTE L'INVENTION

La présente invention concerne un module d'appareillage électrique à engager dans une boîte électrique, comportant un boîtier en matériau isolant qui comprend une paroi latérale fermée à l'avant par une paroi avant pour délimiter un espace intérieur de réception d'un mécanisme électrique.

L'invention trouve une application particulièrement avantageuse dans la réalisation d'un module d'appareillage présentant par exemple une fonction d'interrupteur, de va-et-vient, de variateur électrique, de prise de courant, de prise réseau (RJ45), de prise de téléphone (RJ11), de prise VDI ou équivalent (HDMI,...), de voyant, de thermostat, ou encore de détecteur (de fumée, d'inondation, de température, de mouvement ou de lumière).

Elle concerne par ailleurs une boîte électrique à encastrer dans une cavité pratiquée dans une paroi, comportant une paroi latérale qui est ouverte vers l'avant selon un axe principal et qui définit intérieurement un volume d'accueil d'un module d'appareillage électrique, des moyens de retenue de ladite paroi latérale dans ladite cavité, et des moyens de blocage dudit module d'appareillage électrique dans ledit volume d'accueil.

Elle concerne également un appareillage électrique à encastrer dans une cavité pratiquée dans une paroi, comportant une boîte électrique et un module d'appareillage électrique tels que précités.

Elle concerne aussi un procédé de remplacement d'un ancien module d'appareillage électrique par un nouveau module d'appareillage électrique.

### ARRIERE-PLAN TECHNOLOGIQUE

Actuellement, les appareillages électriques à encastrer présentent tous des architectures similaires.

Un tel appareillage électrique comporte ainsi une boîte électrique ouverte à l'avant et destinée à être fixée au travers d'une ouverture pratiquée dans la cloison creuse, un support d'appareillage en forme de cadre à rapporter sur la face avant ouverte de la boîte électrique, un mécanisme d'appareillage (par exemple d'interrupteur ou de prise de courant) à bloquer dans l'ouverture délimitée par le support d'appareillage, et une plaque de finition à fixer sur le support d'appareillage de telle manière qu'il cache ce dernier et qu'il borde esthétiquement le mécanisme d'appareillage.

Le mécanisme d'appareillage comporte en particulier un socle isolant qui loge des bornes de connexion pour sa connexion au réseau électrique local et qui est fermé à l'avant par un enjoliveur accessible à l'usager (une touche basculante ou enfonçable dans le cas d'un interrupteur ou d'un va-et-vient, un puits de branchement dans le cas d'une prise de courant, ...).

Ce socle isolant est généralement encliqueté de manière définitive dans le support d'appareillage, tandis que le support d'appareillage est fixé sur la boîte électrique au moyen de vis dont les têtes s'appuient sur le support d'appareillage et dont les corps filetés sont vissés dans des puits de vissage prévus en correspondance dans la boîte électrique.

Par conséquent, lorsque l'usager souhaite remplacer le mécanisme d'appareillage par un mécanisme optimisé, il est forcé de dévisser les vis qui maintiennent le support d'appareillage sur la boîte électrique, de retirer ce support d'appareillage, de déconnecter le mécanisme porté par ce support des fils électriques issus du réseau électrique local, de remplacer ce support et ce mécanisme par un autre support d'appareillage portant le nouveau mécanisme d'appareillage, de reconnecter ce nouveau mécanisme, puis de revisser les vis, ce qui s'avère fastidieux.

Pour installer un tel appareillage électrique dans une ouverture pratiquée dans une cloison creuse, il est par ailleurs nécessaire de mettre en œuvre un nombre important d'opérations.

Il est ainsi nécessaire de tirer au moins une gaine de cheminement de câble au travers de l'ouverture pratiquée dans la cloison creuse, d'engager l'extrémité de chaque gaine dans la boîte électrique, de fixer la boîte électrique dans l'ouverture pratiquée dans la cloison creuse en refoulant chaque gaine dans la cloison creuse, de visser le support d'appareillage sur la boîte électrique en prenant soin de le placer à la verticale, de connecter les fils électriques issus de chaque gaine aux bornes du mécanisme d'appareillage, de bloquer le mécanisme d'appareillage dans le support d'appareillage, et de rapporter la plaque de finition sur le support d'appareillage.

Ces opérations sont longues et fastidieuses à mettre en œuvre.

Le nombre d'éléments nécessaires à la fixation de l'appareillage électrique sur la cloison creuse est en outre important, ce qui génère un surcoût.

On connaît alors du document DE9106123U un appareillage électrique dont l'assemblage s'avère plus facile et rapide à mettre en œuvre.

Cet appareillage électrique comporte un mécanisme d'apareillage à engager dans une boîte électrique dont la paroi latérale présente deux fenêtres diamétralement opposées.

Tel qu'il est décrit dans ce document, le mécanisme d'appareillage comporte un socle et deux pattes latérales opposées, qui s'étendent depuis le fond du socle vers l'avant et qui portent des dents d'encliquetage adaptées à s'accrocher aux fenêtres de la boîte électrique. Ces dents d'encliquetage sont plus précisément prévues pour traverser ces fenêtres et pour s'accrocher à la paroi murale. Autrement formulé, ces dents d'encliquetage permettent non seulement de maintenir le mécanisme d'appareillage dans la boîte électrique, mais également de bloquer la boîte électrique dans la paroi murale.

Il est par ailleurs prévu d'utiliser dans ce document une plaque de finition qui se fixe au bord de la boîte électrique et qui coopère avec les extrémités avant des pattes latérales pour verrouiller ces pattes latérales dans les fenêtres de la paroi latérale de la boîte électrique, de manière à éviter qu'elles ne se décrochent de ces fenêtres.

L'inconvénient majeur de cet appareillage électrique est qu'il nécessite de ménager dans la paroi murale des cavités permettant d'accueillir les dents d'encliquetage du mécanisme d'appareillage.

Ménager de telles cavités dans la paroi murale s'avère en pratique très difficile à réaliser. En outre, dans le cas où la paroi murale est en plâtre (friable), ce type de fixation ne présente pas une robustesse suffisante eu égard aux normes en vigueur.

Les dimensions des cavités pratiquées dans la paroi murale doivent en outre être très précisément ajustées (en fonction des dimensions des pattes latérales du mécanisme).En pratique, un tel degré de précision est difficilement atteignable lorsqu'il s'agit de creuser à l'aide d'outils les cavités dans la paroi murale.

En d'autres termes, le risque est grand que, soit l'ensemble ne puisse pas être monté sur la paroi, soit il présente une fois monté sur la paroi un très grand jeu.

Un autre inconvénient est que les dimensions des pattes latérales (notamment la position des dents d'encliquetage et des extrémités avant des pattes latérales) doivent être très précisément ajustées pour qu'elles puissent assurer leur fonction de blocage du mécanisme vers l'avant (au niveau des dents d'encliquetage) et vers l'arrière (au niveau des extrémités avant des pattes flexibles) et leur fonction de blocage de la boîte dans la paroi. En pratique, un tel degré de précision est difficilement atteignable pour un mécanisme destiné à être fabriqué en grande série.

Par ailleurs, s'il est précisé dans ce document que l'ensemble peut être démonté en enlevant la plaque de finition puis en utilisant un tournevis pour agir sur les extrémités avant des pattes latérales, par les côtés du mécanisme, afin de faire fléchir les pattes latérales, il n'en demeure pas moins que ce démontage s'avère fastidieux et nécessite l'utilisation d'un outil.

Enfin, l'utilisation d'une plaque de finition se fixant au bord avant de la boîte électrique s'avère en pratique très gênant. En effet, il est fréquent, après avoir engagé la boîte électrique dans la paroi murale, de recouvrir cette dernière d'un revêtement (papier-peint, enduit, ...), de sorte que le bord avant de la boîte électrique n'est plus accessible et qu'il n'est plus possible d'y fixer la plaque de finition.

On connaît également du document DE7030837U un appareillage électrique qui comporte un boîtier logé dans une boîte et équipé de deux griffes pouvant basculer vers l'extérieur lorsque l'utilisateur repousse deux glissières vers l'arrière de la boîte.

On connaît du document EP2200416 un mécanisme électrique prévu pour être fixé dans un support. Ce support présente deux rebords dans lesquels sont ménagées des fentes. Le mécanisme électrique comprend quant à lui une ou deux nervures prévues pour s'engager dans les fentes afin d'assurer un bon maintien latéral du mécanisme dans son support. Des pattes flexibles sont en outre prévues pour s'accrocher dans les fentes afin de pouvoir clipser le mécanisme électrique sur le support.

On connaît aussi du document US2934590 un appareillage électrique comprenant un double mécanisme de prise de courant dont le socle est équipé à l'arrière d'une sorte d'étrier métallique en U. Les branches du U portent chacune une lamelle d'encliquetage repliée en V. Chaque lamelle d'encliquetage présente un fond en forme de diamant pour l'encliquetage d'une plaque de finition, et une extrémité libre qui porte une languette prévue pour s'engager dans une fente prévue en correspondance dans la paroi latérale d'une boîte électrique.

### OBJET DE L'INVENTION

Afin de remédier aux inconvénients précités de l'état de la technique, la présente invention propose un module d'appareillage faisant office de support et dont le remplacement est facilité.

Plus particulièrement, on propose selon l'invention un module d'appareillage électrique tel que défini dans la revendication 1.

Ainsi, l'extraction du module d'appareillage électrique hors de la boîte électrique peut être opérée sans difficulté. On pourra ainsi prévoir qu'elle soit opérée sans outil.

Par ailleurs, grâce à l'invention, le module d'appareillage fait simultanément office de support d'appareillage et de mécanisme d'appareillage, ce qui facilite sa mise en place dans la boîte électrique et réduit son coût.

Enfin, puisqu'il n'est plus nécessaire d'utiliser de support d'appareillage, le module d'appareillage ne présente plus un volume limité à la taille de l'ouverture centrale de ce support d'appareillage, mais peut présenter un volume plus important pour accueillir un mécanisme électrique optimisé, de plus grandes dimensions. D'ailleurs, puisque les moyens d'encliquetage sont manoeuvrables par l'avant du boîtier du module d'appareillage, ces moyens de manœuvre et ces moyens d'encliquetage peuvent se loger dans le boîtier, ce qui laisse davantage d'espace dans la boîte électrique pour le boîtier.

Préférentiellement, les moyens d'encliquetage ont pour fonction exclusive de fixer le module d'appareillage dans la boîte. Ils n'interviennent en revanche pas dans la fixation de la boîte à la paroi murale. Il est alors possible d'équiper la boîte de moyens de fixation à la paroi murale qui sont distincts de ces moyens d'encliquetage et qui, au contraire de ceux divulgués dans le document DE9106123U sont adaptés à s'accrocher à tout type de paroi, sans qu'il ne soit nécessaire de prévoir dans la paroi des aménagements dédiés à cette fixation.

D'autres caractéristiques avantageuses et non limitatives du module d'appareillage électrique conforme à l'invention sont définies dans les revendications 2 à 12.

L'invention propose également un appareillage électrique tel que défini dans la revendication 13.

D'autres caractéristiques avantageuses et non limitatives de cet appareillage conforme à l'invention sont définies dans les revendications 14 à 20.

L'invention propose également un procédé de remplacement d'un ancien module d'appareillage électrique par un nouveau module d'appareillage électrique, tel que défini dans les revendications 21 à 23.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique en perspective éclatée d'un appareillage électrique à encastrer dans une cloison creuse, sur laquelle apparaît un module d'appareillage électrique selon l'invention et une boîte électrique ;
- la figure 2 est une vue de détail du trottoir extérieur de la boîte électrique de la figure 1 ;
- la figure 3 est une vue de détail du trottoir extérieur du module d'appareillage électrique de la figure 1 ;
- les figures 4 et 5 sont des vues schématiques en perspective d'une première variante de réalisation du module d'appareillage électrique et de la boîte électrique destinée à accueillir ce module d'appareillage électrique ;
- les figures 6 et 7 sont des vues schématiques en perspective d'une seconde variante de réalisation du module d'appareillage électrique et de la boîte électrique destinée à accueillir ce module d'appareillage électrique ; et
- les figures 8 et 9 sont des vues schématiques en perspective de deux autres variantes de réalisation du module d'appareillage électrique de la figure 1.

En préliminaire, on notera que les éléments identiques ou similaires des différentes variantes de réalisation de l'invention représentés sur les différentes figures seront, dans la mesure du possible, référencés par les mêmes signes de référence et ne seront pas décrits à chaque fois.

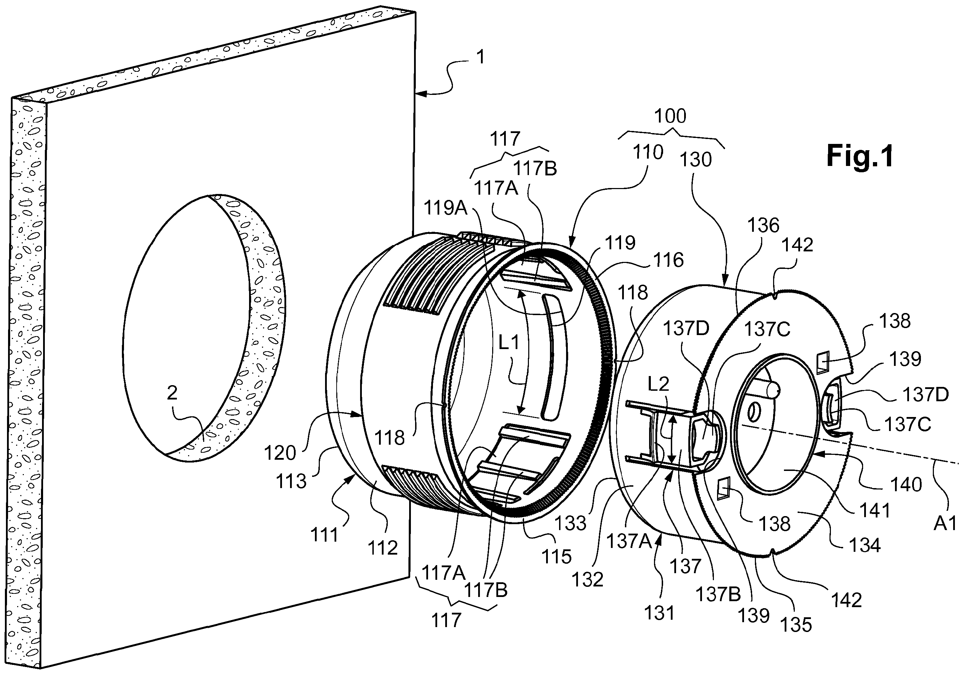

Sur la figure 1, on a représenté un appareillage électrique 100 comprenant un module d'appareillage électrique 130 et une boîte électrique 110.

Cet appareillage électrique 100 est du type à encastrer dans une cavité 2 pratiquée dans une paroi 1.

La boîte électrique 110 permet alors non seulement de fixer rigidement le module d'appareillage électrique 130 dans la paroi 1 mais également de le protéger.

Par module d'appareillage électrique, on entend tout type de module tel qu'un module de prise de courant, d'interrupteur, de va-et-vient, de variateur électrique, de prise réseau (RJ45), de prise de téléphone (RJ11), de voyant, ou encore de détecteur (de fumée, d'inondation, de température, de mouvement ou de lumière).

Dans le mode de réalisation représenté sur les figures, le module d'appareillage électrique 130 est plus précisément prévu pour être encastré dans une cloison creuse.

On rappelle à ce sujet que, de manière connue, une telle cloison creuse est généralement composée d'une ossature métallique (formée de montants verticaux et de rails horizontaux non représentés) et de panneaux de plâtre 1 rapportés sur l'une au moins des deux faces de l'ossature métallique.

Comme le montre la figure 1, la cavité pratiquée dans cette cloison creuse est ici simplement formée par une ouverture circulaire 2 réalisée à la scie cloche dans l'un des panneaux de plâtre 1.

Dans la description, les termes « avant » et « arrière » seront alors utilisés par rapport à la direction du regard de l'installateur du module d'appareillage électrique 130 dans cette ouverture circulaire 2. Ainsi, les termes avant et arrière désigneront respectivement le lieu tourné vers l'extérieur de la cloison creuse et le lieu tourné vers l'intérieur de la cloison creuse.

Sur la figure 1, on a représenté un mode de réalisation particulier de la boîte électrique 110, qui permet d'illustrer la manière selon laquelle le module d'appareillage électrique 130 peut se fixer dans la cloison creuse.

Cette boîte électrique 110 comprend un corps 111 qui présente ici une forme générale cylindrique mais qui pourrait bien entendu présenter une forme différente, notamment parallélépipédique.

Ce corps 111 comporte une paroi latérale 112 tubulaire de révolution autour d'un axe A1, qui est fermée à l'arrière par une paroi de fond 113 et qui est ouverte vers l'avant. Le corps 111 délimite ainsi un logement intérieur d'accueil du module d'appareillage électrique 130.

Pour sa fixation dans l'ouverture circulaire 2 pratiquée dans le panneau de plâtre 1, le corps 111 de la boîte électrique 110 comporte un trottoir extérieur 115 qui longe extérieurement le bord de l'ouverture avant de la paroi latérale 112 et qui est adapté à prendre appui contre la face avant du panneau de plâtre 1, tout autour de l'ouverture circulaire 2. Ainsi, ce trottoir extérieur 115 permet de bloquer le corps 111 de la boîte électrique 110 vers l'arrière.

Pour le bloquer vers l'avant, la paroi latérale 112 de la boîte électrique 110 comporte des moyens de fixation 117 qui sont adaptés à s'accrocher à l'arrière du panneau de plâtre 1.

Ces moyens de fixation seront décrits plus en détail dans la suite de cet exposé.

Comme le montre la figure 1, le module d'appareillage 130 à rapporter dans cette boîte électrique 110 est conçu pour offrir à l'utilisateur la fonction électrique souhaitée, ici une fonction de prise de courant. Il se présente sous la forme d'un bloc « tout en un », adapté à être rapporté directement dans le corps 111 de la boîte électrique 110.

Ce module d'appareillage électrique 130 comporte un boîtier 131 en matériau isolant, de forme sensiblement identique à celle du volume intérieur délimité par le corps 111 de la boîte électrique 110. Il présente donc ici une forme sensiblement cylindrique de révolution autour d'un axe A1. La forme de ce boîtier 131 permet donc de profiter de l'ensemble du volume intérieur délimité par le corps 111 de la boîte électrique 110.

Comme le montre la figure 1, ce boîtier 131 comprend une paroi latérale 132 cylindrique de révolution autour de l'axe A1, qui est ici fermée à l'arrière par une paroi arrière 133 sensiblement circulaire et qui est fermée à l'avant par une paroi avant 134 sensiblement circulaire. Le boîtier 131 délimite ainsi un espace intérieur de réception d'un mécanisme électrique 140 (ici un mécanisme de prise de courant).

Le boîtier 131 comporte également un trottoir extérieur 135 qui borde à l'avant la paroi latérale 132 et qui est conçu pour s'appuyer contre la face avant du trottoir extérieur 115 de la boîte électrique 110.

Selon une caractéristique particulièrement avantageuse de l'invention, le boîtier 131 comporte des moyens d'encliquetage 137 adaptés à s'accrocher à la boîte électrique 110, et, pour les décrocher de la boîte électrique 110, des moyens de manœuvre 137C de ces moyens d'encliquetage 137 qui sont accessibles par l'avant, au travers d'une ouverture d'accès 139 prévue dans la paroi avant 134 du boîtier 131.

Selon l'invention, les moyens d'encliquetage 137 comportent au moins un organe d'accrochage 137A mobile entre une position rentrée dans laquelle il n'entrave pas l'introduction du boîtier 131 dans la boîte électrique 110 et une position sortie dans laquelle il est adapté à s'accrocher directement à la boîte électrique 110. Les moyens de manœuvre 137C sont alors conçus pour ramener l'organe d'accrochage 137A en position rentrée.

Ici, chaque organe d'accrochage 137A est positionné, au repos, en position sortie. Par conséquent, les moyens de manœuvre 137C sont conçus pour rétracter chaque organe d'accrochage 137A en position rentrée.

En variante, on aurait pu prévoir qu'au repos, chaque organe d'accrochage soit positionné en position rentrée, auquel cas les moyens de manœuvre seraient conçus pour déployer chaque organe d'accrochage 137A en position sortie.

En pratique, comme le montre la figure 1, les moyens d'encliquetage 137 comportent deux pattes de flexion 137B qui sont découpées dans la paroi latérale 132 du boîtier 131, qui portent chacune sur leurs faces externes une dent d'encliquetage 137A (faisant office d'organe d'accrochage), et qui sont manœuvrables par des leviers 137C.

Les deux pattes de flexion 137B sont situées de manière diamétralement opposée par rapport à l'axe A1. Elles s'étendent en longueur depuis le bord avant de la paroi latérale 132 du boîtier 131, vers l'arrière. Chaque patte de flexion 137B présente une forme de rectangle dont trois des bords sont libres et dont le quatrième bord, à savoir ici le bord arrière, forme la racine de la patte de flexion 137B en ce sens qu'il se raccorde au reste de la paroi latérale 132 du boîtier 131 pour former une charnière. Au repos, ces pattes de flexion 137B s'étendent dans le prolongement du reste de la paroi latérale 132 du boîtier 131.

Chaque dent d'encliquetage 137A est alors située à distance de la charnière. Chaque dent d'encliquetage 137A présente une face avant plane et orthogonale à l'axe A1 et une face arrière inclinée par rapport à l'axe A1.

La face arrière de chaque dent d'encliquetage 137A forme une rampe permettant à la patte de flexion 137B de se déformer élastiquement vers l'intérieur lorsque le boîtier 131 est engagé dans la boîte électrique 110, de manière que la dent d'encliquetage 137A correspondante ne forme pas obstacle à l'engagement du module d'appareillage électrique 130 à l'intérieur de la boîte électrique 110.

La face avant de chaque dent d'encliquetage 137A est quant à elle prévue pour s'accrocher à une face de butée 119A prévue en correspondance sur la boîte électrique 110 et s'étendant orthogonalement à l'axe A1. Ici, cette face de butée est formée par le bord avant 119A d'une fenêtre rectangulaire 119 prévue dans la paroi latérale 112 de la boîte électrique 110. Cette face de butée forme donc un moyen de blocage du module d'appareillage électrique 130 dans la boîte électrique 110.

Chaque dent d'encliquetage 137A est par ailleurs prévue pour se loger entièrement dans la fenêtre rectangulaire 119 prévue dans la paroi latérale 112 de la boîte électrique 110. Il n'est pas prévu qu'elle fasse saillie à l'extérieur de cette paroi latérale 112, de manière qu'elle ne vient pas interférer avec le panneau de plâtre 1.

Ici, il est prévu deux fenêtres rectangulaires 119 distinctes et diamétralement opposées, qui présentent chacune une longueur L1 strictement supérieure à la longueur L2 des dents d'encliquetage 137A. Ainsi, lorsque les dents d'encliquetage 137A s'accrochent aux bords avant 119A des fenêtres rectangulaires 119, elles ne bloquent pas la mobilité en rotation du boîtier 131 par rapport à la boîte électrique 110 autour de l'axe A1.

Comme cela apparaît clairement sur la figure 1, il est prévu un levier 137C pour manœuvrer chaque patte de flexion 137B. Chacun de ces leviers 137C se présente sous la forme d'une anse raccordée à cette patte de flexion 137B.

Chaque levier 137C comporte ainsi une paroi semi-circulaire autour d'un axe parallèle à l'axe A1, qui se raccorde par ses deux bords d'extrémité latéraux à la face interne de la patte de flexion 137B pour délimiter avec celle-ci une cavité 137D dans laquelle l'installateur peut insérer un doigt.

Les ouvertures prévues dans la paroi avant 134 du boîtier 131 pour accéder à ces cavités 137D sont alors ici formées par des encoches 139 diamétralement opposées prévues en creux dans le bord de cette paroi avant 134 du boîtier 131.

Alors, en insérant deux doigts dans ces deux cavités 137D et en pinçant les deux leviers 137C l'un vers l'autre, l'installateur peut manœuvrer les pattes de flexion 137B. Il peut ainsi forcer chaque dent d'encliquetage 137A à se dégager de chaque fenêtre rectangulaire 119 de la boîte électrique 110, ce qui permet d'extraire à loisir le boîtier 131 hors de la boîte électrique 110.

De ce fait, après que le module d'appareillage électrique 130 a été encliqueté dans la boîte électrique 110, l'installateur peut aisément l'en extraire afin par exemple de le remplacer par un nouveau module d'appareillage électrique optimisé.

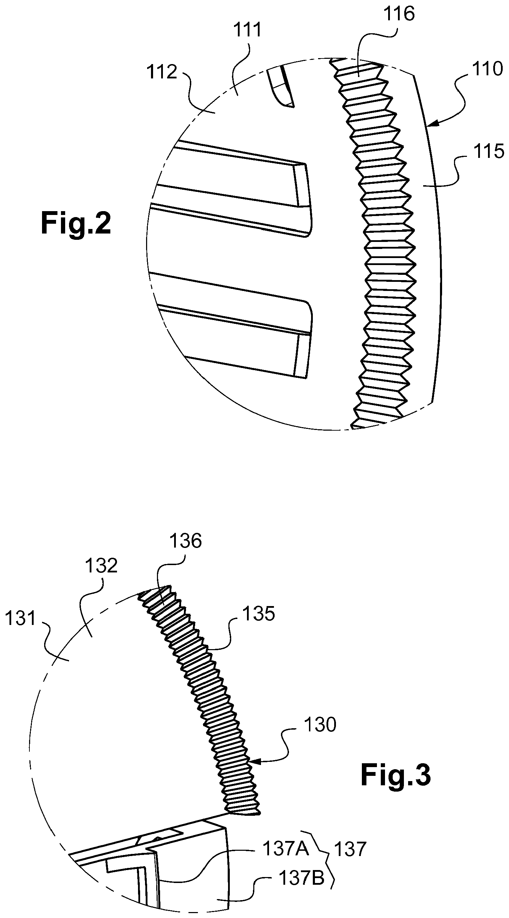

Comme le montrent les figures 1 et 3, le trottoir extérieur 135 présente une face avant plane et orthogonale à l'axe A1, qui s'étend dans le prolongement de la face avant de la paroi avant 134 du boîtier 131, et une face arrière inclinée vers l'extérieur, qui présente donc une forme tronconique.

Comme le montrent les figures 1 et 2, l'arête intérieure 136 prévue à la jonction de la paroi latérale 112 et du trottoir extérieur 115 de la boîte électrique 110 est alors chanfreinée en correspondance, pour présenter une forme tronconique identique. De cette manière, lorsque le boîtier 131 du module d'appareillage électrique 130 est engagé dans la boîte électrique 110, son trottoir extérieur 135 s'appuie par sa face arrière 136 contre l'arête chanfreinée 116 de la boîte électrique 110, ce qui permet de centrer automatiquement le boîtier 131 selon l'axe A1 de la boîte électrique 110.

Avantageusement, le module d'appareillage électrique 130 et la boîte électrique 110 comportent des moyens de blocage angulaire du boîtier 131 dans le corps 111 de la boîte électrique 110 autour de l'axe A1.

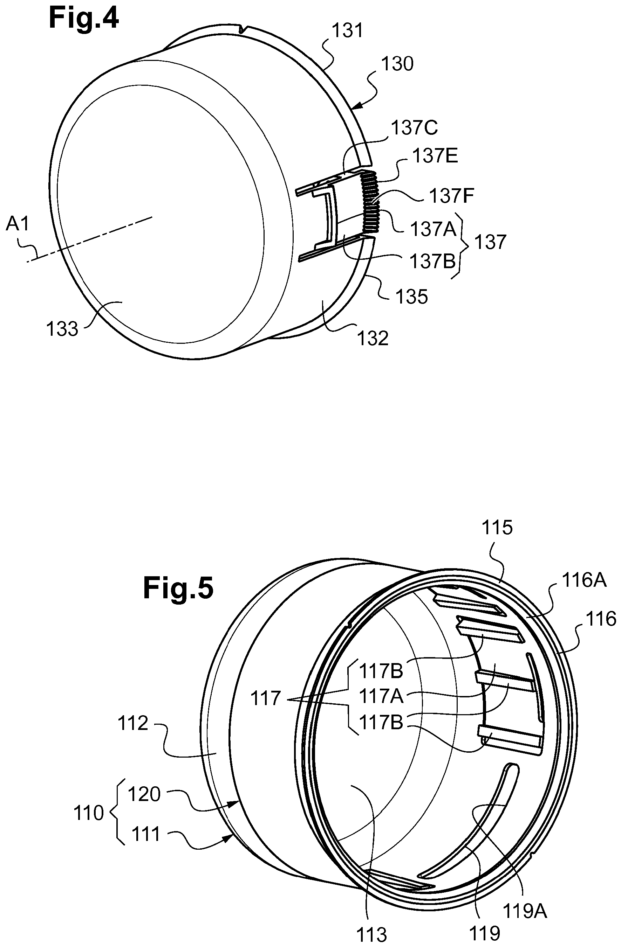

Comme cela sera décrit infra en référence aux figures 4 à 7, ces moyens de blocage angulaire pourront présenter diverses formes.

Tels qu'ils sont représentés sur les figures 1 à 3, ces moyens de blocage angulaire comportent deux séries de crans qui sont respectivement disposées sur le corps 111 de la boîte électrique 110 et sur le boîtier 131 du module d'appareillage électrique 130 et qui sont adaptées à s'engrener.

Ainsi, comme le montre la figure 2, l'arête intérieure 116 chanfreinée de la boîte électrique 110 est crantée sur l'ensemble de son pourtour. Elle présente ici 360 crans en saillie qui sont régulièrement répartis autour de l'axe A1. Ces crans sont ici chacun profilés suivant un axe radial par rapport à l'axe A1, et présentent un même profil triangulaire.

Comme le montre la figure 3, la face arrière 136 du trottoir extérieur 135 alors est crantée en correspondance. Puisque le trottoir extérieur 135 du boîtier 131 du module d'appareillage électrique 130 est interrompu au niveau des pattes de flexion 137B, la série de crans prévue sur le boîtier est également interrompue au niveau de ces deux pattes de flexion 137B.

Grâce à ces crans, lorsque le module d'appareillage électrique 130 sera rapporté dans la boîte électrique 110, la face arrière 136 crantée de son trottoir extérieur 135 viendra engrener l'arête intérieure 116 chanfreinée et crantée de la boîte électrique 110.

Les moyens d'encliquetage 137 du boîtier 131 ne viendront alors s'accrocher aux fenêtres 119 prévues dans la boîte électrique 110 que lorsque les crans de la face arrière 136 du trottoir extérieur 135 du boîtier 131 seront venus se loger au fond des crans de l'arête intérieure 116 de la boîte électrique 110.

A ce stade, il demeurera toutefois possible de modifier la position angulaire du boîtier 131 dans la boîte électrique 110 autour de l'axe A1, en manœuvrant les leviers 137C afin d'extraire partiellement le boîtier 131 hors de la boîte électrique 110 de manière à dégager les crans les uns des autres.

Bien entendu, en variante, on pourrait prévoir que le module d'appareillage électrique et/ou la boîte électrique présentent un nombre réduit de crans. On pourrait ainsi prévoir que le module d'appareillage électrique ne comporte qu'un cran, venant s'engager dans l'un ou l'autre des 360 crans de la boîte électrique.

Tel qu'il est représenté sur la figure 1, le boîtier 131 loge un mécanisme électrique 140, ici un mécanisme de prise de courant, de telle manière que seul l'enjoliveur 141 de ce mécanisme électrique 140 émerge à l'avant du boîtier 131.

La paroi avant 134 du boîtier 131 présente à cet effet en son centre une fenêtre d'accès à l'intérieur du boîtier 131 qui est fermée par l'enjoliveur 141.

Puisque le mécanisme électrique 140 présente une fonction de prise de courant, l'enjoliveur 141 forme un puits de réception d'une fiche électrique.

Le fond de l'enjoliveur 141 est donc percé de deux premières ouvertures de passage des broches de la fiche électrique et d'une troisième ouverture de passage d'une broche de terre du mécanisme électrique 140.

La partie interne du mécanisme électrique 140, qui est logée à l'intérieur du boîtier 131 et qui n'est pas représentée sur les figures, comporte alors trois bornes de connexion électrique. Ces trois bornes de connexion électrique sont respectivement connectées à la broche de terre et à deux alvéoles de réception des broches de la fiche électrique (situées à l'arrière des deux premières ouvertures précitées). Elles sont par ailleurs conçues pour se connecter au réseau électrique local.

La manière selon laquelle ces trois bornes de connexion électrique se connectent au réseau électrique local ne faisant pas en propre l'objet de la présente invention, elle ne sera pas décrite en détail.

On pourra toutefois envisager que ces trois bornes de connexion électrique soient accessibles par l'arrière du boîtier 131, de telle manière qu'on puisse y connecter trois fils électriques de phase, de neutre et de terre issus du réseau électrique local.

On pourra aussi envisager que ces trois bornes de connexion électrique fassent saillie à l'arrière du boîtier 131, de telle manière qu'elles puissent se connecter à un bornier de connexion qui serait prévu au fond de la boîte électrique et qui serait par ailleurs connecté aux trois fils électriques issus du réseau électrique local.

Ces bornes de connexion électrique seront quoi qu'il en soit maintenues dans des logements d'accueil prévus à l'intérieur du boîtier 131 et délimités par des cloisons internes qui viennent de formation avec la paroi arrière 133 et/ou avec la paroi latérale 132 du boîtier 131.

Comme le montre encore la figure 1, la paroi avant 134 du boîtier 131 comporte par ailleurs des moyens d'assujettissement 138 d'une plaque de finition (non représentée).

De manière classique, une telle plaque de finition est prévue pour border l'enjoliveur 141 du mécanisme électrique 140 et pour recouvrir esthétiquement le boîtier 131 du module d'appareillage électrique 130.

La paroi avant 134 du boîtier 131 présente alors deux trous 138 dans lesquels pourront s'encliqueter des plots d'encliquetage prévus en correspondance en saillie de la face arrière de la plaque de finition.

La fixation de la plaque de finition au boîtier 131 (et non à la boîte électrique 110) est avantageuse. En effet, il est fréquent, après avoir engagé la boîte électrique 110 dans l'ouverture circulaire 2 pratiquée dans le panneau de plâtre 1, de recouvrir ce dernier d'un revêtement (papier-peint, enduit, ...), de sorte que le bord avant de la boîte électrique n'est plus accessible pour y fixer la plaque de finition. Au contraire, la paroi avant 134 du boîtier 131 n'est pas prévu pour être recouverte par ce revêtement, si bien qu'elle reste facilement accessible pour le montage de la plaque de finition.

Ici, les parois arrière 133 et avant 134 du boîtier sont monoblocs. Elles sont ici réalisées d'une seule pièce par moulage en matière plastique (par exemple en polypropylène). Tandis que l'une d'entre elles vient de formation avec une partie au moins de la paroi latérale 132, l'autre est encliquetée sur la paroi latérale 132.

Comme le montre la figure 1, les moyens de fixation 117 précités de la boîte électrique 110 dans l'ouverture circulaire 2 pratiquée dans le panneau de plâtre 1 sont d'un type particulier.

Ils comportent en l'espèce quatre volets 117A rectangulaires découpés dans la paroi latérale 112 de la boîte électrique 110, dont trois des bords sont libres et dont le quatrième bord, à savoir ici le bord avant, se raccorde au reste de la paroi latérale 112 par deux pattes formant charnière. Au repos, les quatre volets 117A sont en position rentrée, c'est-à-dire que leurs faces externes sont situées dans le prolongement de la face externe du reste de la paroi latérale 112 de la boîte électrique 110.

Ces quatre volets 117A comportent chacun, en saillie de leurs faces intérieures, des rampes 117B dont l'épaisseur croît depuis l'avant vers l'arrière. Ainsi, lorsque le module d'appareillage électrique 130 est rapporté dans la boîte électrique 110, il appuie sur ces rampes 117B, ce qui permet de déployer les volets 117A en position sortie, c'est-à-dire en saillie de la face externe de la paroi latérale 112.

Ici, la paroi latérale 112 du corps 111 de la boîte électrique 110 porte un bandeau périphérique 120 en matériau compressible, qui recouvre notamment les volets 117A. Ce bandeau périphérique 120 présente ici, au niveau de chacun des volets 117A, des nervures parallèles en saillie sur sa face externe.

De cette manière, lorsqu'ils se déploient, les volets 117A compriment les nervures du bandeau périphérique 120 contre le bord de l'ouverture circulaire 2 pratiquée dans le panneau de plâtre 1, ce qui permet de fixer la boîte électrique 110 dans cette ouverture circulaire 2.

Par conséquent, les moyens de fixation 117 forment avec le trottoir extérieur 115 des moyens de retenue de la boîte électrique 110 dans cette ouverture circulaire 2.

Ici, la paroi de fond 113 de la boîte électrique 110 comporte un opercule défonçable (non visible) qui permet de dégager un passage pour une gaine de cheminement de câbles dont sont issus les fils électriques à connecter aux bornes de connexion électrique du module d'appareillage électrique 130.

L'installation de l'appareillage électrique 100 dans l'ouverture circulaire 2 pratiquée dans le panneau de plâtre 1 est alors réalisée de la manière suivante.

L'extrémité libre de la gaine de cheminement de câbles est tout d'abord tirée à l'extérieur de la cloison creuse, au travers de l'ouverture circulaire 2.

L'installateur engage alors l'extrémité de cette gaine de cheminement de câbles dans la boîte électrique 110, au travers de l'ouverture préalablement dégagée à l'aide de l'opercule défonçable. Il connecte alors les extrémités libres des fils électriques issus de cette gaine de cheminement de câbles au module d'appareillage électrique 130.

Il rapporte ensuite la boîte électrique 110 dans l'ouverture circulaire 2 pratiquée dans le panneau de plâtre 1, en prenant soin que son trottoir périphérique 115 s'applique bien contre le panneau de plâtre 1.

A ce stade, l'installateur doit régler l'orientation de la boîte électrique 110 dans l'ouverture circulaire 2. Il s'aide pour cela de deux encoches 118 diamétralement opposées, qui sont prévues en creux dans le bord extérieur du trottoir périphérique 115 de la boîte électrique 110 et qui indiquent l'horizontale.

L'installateur rapporte alors directement le module d'appareillage électrique 130 dans la boîte électrique 110, en prenant soin que la face arrière 136 crantée de son trottoir extérieur 135 engrène bien les crans de l'arête intérieure 116 de la boîte électrique 110 et que ses dents d'encliquetage 137A s'accrochent bien aux bords avant 119A des fenêtres 119 prévues dans la paroi latérale 112 de la boîte électrique 110.

Lors de cet engagement, le boîtier 131 du module d'appareillage électrique 130 appuie contre les rampes 117B des volets 117A de la boîte électrique 110, ce qui permet de bloquer cette dernière dans l'ouverture circulaire 2 pratiquée dans le panneau de plâtre 1.

Lors de cet engagement, l'installateur doit par ailleurs régler l'orientation du module d'appareillage électrique 130 dans la boîte électrique 110. Il s'aide pour cela de deux encoches 142 diamétralement opposées, qui sont prévues en creux dans le bord extérieur du trottoir périphérique 135 du module d'appareillage électrique 130 et qui indiquent la verticale.

Enfin, l'installateur achève l'installation de l'appareillage électrique 100 en rapportant la plaque de finition sur la paroi avant 134 du boîtier 131 du module d'appareillage électrique 130.

Par la suite, il peut arriver que l'utilisateur souhaite remplacer le module d'appareillage électrique 130, par exemple par un nouveau module d'appareillage optimisé.

Pour ce faire, l'utilisateur retire la plaque de finition, par exemple au moyen d'un tournevis.

Il manœuvre ensuite les leviers 137C de l'ancien module d'appareillage électrique 130 pour dégager les dents d'encliquetage 137A des fenêtres rectangulaires 119 de la boîte électrique 110.

Il extrait alors l'ancien module d'appareillage électrique 130 de la boîte électrique 110 et le remplace par le nouveau module d'appareillage électrique. L'engagement du nouveau module d'appareillage électrique peut bien entendu être opéré sans manœuvrer ses leviers.

Enfin, il rapporte la plaque de finition sur le boîtier du nouveau module d'appareillage électrique 130.

La présente invention n'est nullement limitée au mode de réalisation décrit et représenté, mais l'homme du métier saura y apporter toute variante conforme à son esprit.

Ainsi, sur les figures 4 et 5, on a représenté une première variante de réalisation du module d'appareillage électrique 130 et de la boîte électrique 110.

En préliminaire, on notera que, sur la figure 4, on n'a pas représenté les moyens de connexion du module d'appareillage électrique 130 aux fils électriques issus du réseau électrique local, puisqu'ils ne font pas l'objet de la présente invention. Sur la figure 5, on notera également que, pour les mêmes raisons, on n'a pas représenté l'opercule défonçable au fond de la boîte électrique 110.

Dans cette variante, comme le montre la figure 4, le trottoir extérieur 135 du boîtier 131 du module d'appareillage électrique 130 n'est pas interrompu au niveau des pattes flexibles 137B.

Ces dernières portent en effet chacune sur leurs faces externes un retour 137E qui s'étend dans le prolongement du trottoir extérieur 135 et qui présente ainsi une face avant orthogonale à l'axe A1 et une face arrière 137F inclinée vers l'extérieur.

Ici, les crans sont exclusivement prévus sur les faces arrière 137F des retour 137E des pattes flexibles 137B. De cette manière, lorsqu'il doit régler la position angulaire du module d'appareillage électrique 130 dans la boîte électrique 110, l'installateur n'a qu'à manœuvrer les leviers 137C pour éloigner les crans de la boîte électrique 110. Il n'est donc plus forcé d'extraire partiellement le module d'appareillage électrique 130 hors de la boîte électrique 110 pour éloigner les crans de la boîte électrique 110.

Dans cette variante, on aurait pu prévoir que la boîte électrique 110 présente une forme identique à celle représentée sur la figure 1. Toutefois, ici, son arête intérieure 116 chanfreinée est dépourvue de crans. Elle porte en revanche un ruban 116A en matériau compressible dans lequel les crans du module d'appareillage électrique 130 peuvent s'accrocher. Ce ruban 116A pourra par exemple être réalisé en SEBS (« *polystyrène-b-poly(éthylène-butylène)-b-polystyrène* ») surmoulé sur l'arête intérieure 116 chanfreinée de la boîte électrique 110.

On observe par ailleurs sur la figure 5 qu'à la différence du bandeau périphérique 120 de la boîte électrique 110 représentée sur la figure 1, ici le bandeau périphérique 120 est dépourvu de nervures parallèles en saillie. La fonction de ce bandeau périphérique 120 demeure toutefois inchangée.

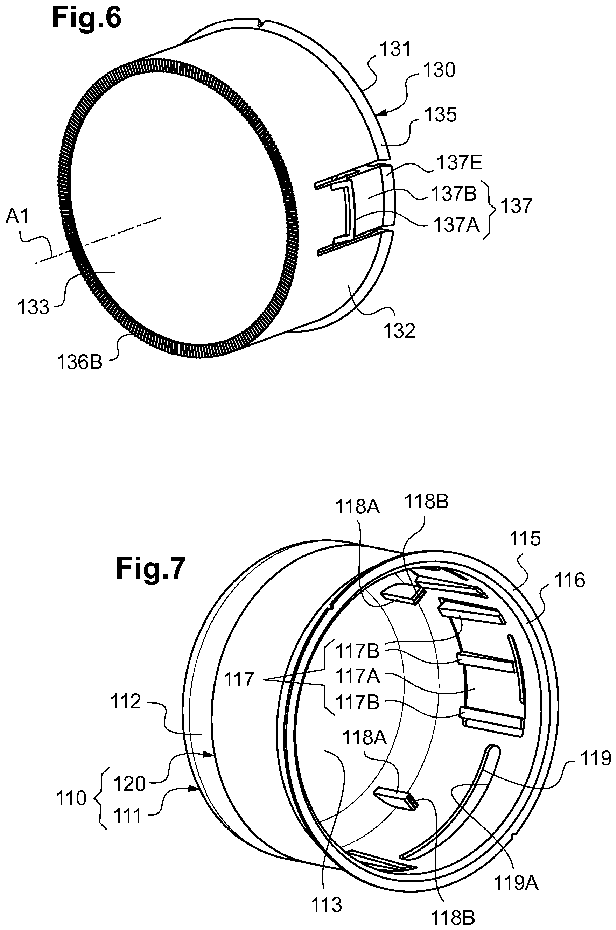

Sur les figures 6 et 7, on a représenté une seconde variante de réalisation du module d'appareillage électrique 130 et de la boîte électrique 110.

En préliminaire, on notera que, sur la figure 6, on n'a pas représenté les moyens de connexion du module d'appareillage électrique 130 aux fils électriques issus du réseau électrique local, puisqu'ils ne font pas l'objet de la présente invention. Sur la figure 7, on notera également que, pour les mêmes raisons, on n'a pas représenté l'opercule défonçable au fond de la boîte électrique 110.

Dans cette variante, comme le montre la figure 6, les pattes flexibles 137B portent sur leurs faces externes des retours 137E qui s'étendent dans le prolongement du trottoir extérieur 135.

Ici, ni ces retours 137E, ni le trottoir extérieur 135 ne porte de cran.

Les crans sont exclusivement prévus en creux dans la face arrière de la paroi arrière 133 du boîtier 131. Ils sont situés le long de l'ensemble de la périphérie de cette paroi arrière 133, sur une bande 136B circulaire autour de l'axe A1.

Dans cette variante, l'arête intérieure 116 chanfreinée de la boîte électrique 110 ne porte ni cran, ni ruban en matière compressible.

Elle porte en revanche, en saillie de la face avant de sa paroi de fond 113, quatre pattes rigides 118A dont les extrémités libres portent des crans 118B adaptés à engrener les crans prévus sur la paroi arrière 133 du boîtier 131.

Ici encore, le bandeau périphérique 120 qui recouvre une partie de la paroi latérale 112 du corps 111 de la boîte électrique 110 est dépourvu de nervures parallèles en saillie.

Dans d'autres variantes de réalisation de l'invention, on aurait pu par exemple remplacer, sur la figure 6, la série de crans prévue à l'arrière du boîtier par un ruban circulaire en matière compressible. De manière plus générale, on aurait pu prévoir que les crans soient situés soit sur la boîte électrique, soit sur le boîtier du module d'appareillage électrique, et que la matière compressible soit située sur l'autre élément. Ces crans et matière compressible pourront alors être positionnés aussi bien du côté arrière de la boîte électrique et du module d'appareillage électrique que du côté avant.

Selon une autre variante de réalisation de l'invention non représentée sur les figures, on pourrait prévoir que les moyens d'encliquetage du module d'appareillage électrique dans la boîte électrique présentent des formes différentes.

Ils pourraient ainsi comporter deux pattes de flexion identiques à celles représentées sur la figure 1, dépourvues de dent d'encliquetage mais revêtues chacune sur leurs faces externes d'une couche compressible adaptée à venir s'accrocher aux bords avant des fenêtres pratiquées dans la paroi latérale de la boîte électrique.

On pourrait par ailleurs prévoir que la boîte électrique comporte, non pas deux fenêtres rectangulaires dont les extrémités limitent l'amplitude de rotation du module d'appareillage, mais une rainure périphérique en creux dans la face intérieure de la paroi latérale de la boîte électrique. Cette rainure périphérique s'étendant sur l'ensemble du contour de la paroi latérale de la boîte électrique, elle ne limiterait pas l'amplitude de rotation du module d'appareillage dans la boîte électrique.

Encore en variante, on pourrait aussi prévoir que le trottoir extérieur de la boîte électrique 110 et/ou du module d'appareillage électrique 130 soit discontinu.

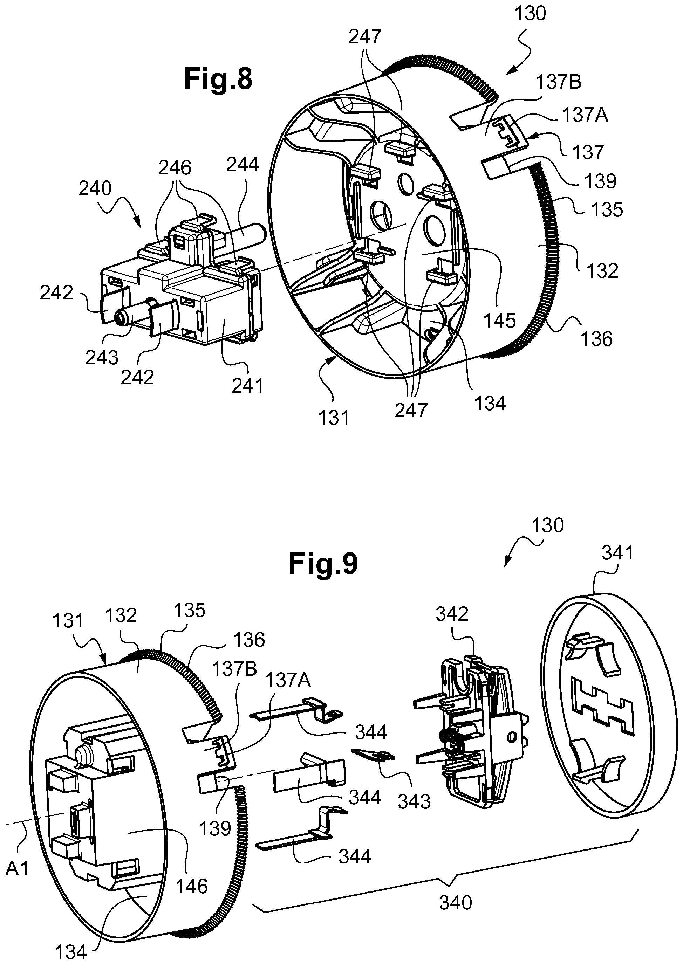

Sur les figures 8 et 9, on a respectivement représenté une troisième et une quatrième variantes de réalisation du module d'appareillage électrique 130.

Dans ces deux variantes, le boîtier 131 du module d'appareillage électrique 130 comporte une paroi latérale 132 (ici encore cylindrique de révolution) qui est fermée à l'avant par une paroi avant 134, mais qui est ouverte à l'arrière. Le fonctionnement de ces deux variantes de réalisation du module d'appareillage électrique 130 est identique à celui exposé supra et ne modifie en rien le principe d'utilisation de l'appareillage électrique.

Son principale avantage est de permettre de fabriquer des boîtiers 131 avec un volume de matière première restreint.

Dans la troisième variante de réalisation du module d'appareillage 130 représentée sur la figure 8, la paroi avant 134 du boîtier 131 présente un renfoncement 145 en creux qui délimite un puits d'insertion d'une fiche électrique.

Le mécanisme électrique 240 logé dans ce boîtier 131 (ici un mécanisme de prise de courant) comporte un socle isolant 241 à l'intérieur duquel sont logés trois bornes de connexion électrique.

Deux de ces bornes de connexion comportent, à l'intérieur du socle 241, des alvéoles de réception des broches de la fiche électrique, et, à l'arrière du socle 241, des broches 242 de connexion au réseau électrique local. La troisième de ces bornes de connexion comporte, à l'avant du socle 241, une broche de terre 244, et, à l'arrière du socle 241, et une broche 243 de connexion au réseau électrique local.

Le socle 241 est alors équipé de moyens de fixation dans le boîtier 131. Ici, ces moyens de fixation se présentent sous la formes de pattes d'encliquetage 246 adaptées à s'accrocher dans des cavités prévues dans des languettes 247 qui s'étendent à partir de la face arrière du fond du renfoncement 145 prévu dans la paroi avant 134 du boîtier 131.

Dans la quatrième variante de réalisation du module d'appareillage 130 représentée sur la figure 9, la paroi avant 134 du boîtier 131 présente un renfoncement 146 en creux qui délimite un logement pour le mécanisme électrique 340.

Le mécanisme électrique 340, qui est ici un mécanisme d'interrupteur, comporte un enjoliveur en deux parties. Cet enjoliveur est constitué d'une touche basculante (non visible sur les figures) qui est prévue pour être montée mobile sur le boîtier 131, et une plaque arrière 341 qui est fixée sur le boîtier 131. Le mécanisme électrique 340 comporte également un système à bascule 342 dont une partie fixe est fixée au boîtier 131 et dont une partie mobile est entraînée par la touche basculante, un contact mobile 343 entraîné par le système à bascule 342, et trois bornes fixes 344.

Ce mécanisme électrique 340 (à l'exclusion de son enjoliveur) est prévu pour être solidarisé à l'intérieur du logement défini par le renfoncement 146 prévu en creux dans la paroi avant 134 du boîtier 131.

## Revendications

1. Module d'appareillage électrique (130) à engager dans une boîte électrique (110), ladite boîte électrique (110) étant du type comportant une paroi latérale (112) qui est ouverte vers l'avant et qui définit intérieurement un volume d'accueil d'un module d'appareillage électrique (130), ledit module d'appareillage électrique (130) comportant :
- un boîtier (131) en matériau isolant qui comprend une paroi latérale (132) fermée à l'avant par une paroi avant (134) pour délimiter un espace intérieur de réception d'un mécanisme électrique (140),
- des moyens d'encliquetage (137) adaptés à s'accrocher à une face de butée (119A) prévue en creux dans la paroi latérale (112) de la boîte électrique (110), qui comportent au moins un organe d'accrochage (137A) qui est porté par une patte flexible (137B) située dans le prolongement de la paroi latérale (132) du boîtier (131) et qui est mobile entre une position rentrée dans laquelle il n'entrave pas l'introduction du boîtier (131) dans ladite boîte électrique (110) et une position sortie dans laquelle il est adapté à s'accrocher directement à ladite face de butée (119A), et
- des moyens de manœuvre (137C) des moyens d'encliquetage (137) qui sont accessibles par l'avant, au travers d'une ouverture d'accès (139) prévue dans ladite paroi avant (134), et qui comportent un levier (137C) raccordé à la patte flexible (137B) pour ramener ledit organe d'accrochage (137A) en position rentrée.
**caractérisé en ce que** la paroi avant (134) du boîtier (131) comprend des moyens d'assujettissement (138) d'une plaque de finition.

2. Module d'appareillage électrique (130) selon la revendication précédente, dans lequel ladite patte flexible (137B) est découpée dans la paroi latérale (132) du boîtier (131) de telle manière qu'au repos, ledit organe d'accrochage (137A) est en position sortie.

3. Module d'appareillage électrique (130) selon l'une des revendications précédentes, dans lequel il est prévu au moins deux organes d'accrochage (137A) qui sont régulièrement répartis autour du boîtier (131).

4. Module d'appareillage électrique (130) selon l'une des revendications précédentes, dans lequel, la paroi latérale (132) du boîtier (131) étant sensiblement de révolution autour d'un axe principal (A1), il est prévu des moyens de blocage angulaire du boîtier (131) dans la boîte électrique (110) autour de l'axe principal (A1).

5. Module d'appareillage électrique (130) selon la revendication 4, dans lequel lesdits moyens de blocage angulaire comportent au moins deux crans (136 ; 137F) distincts situés sur un même cercle centré sur ledit axe principal (A1).

6. Module d'appareillage électrique (130) selon la revendication 4, dans lequel lesdits moyens de blocage angulaire comportent une couche compressible qui s'étend sur au moins un arc de cercle centré sur ledit axe principal (A1).

7. Module d'appareillage électrique (130) selon l'une des revendications 4 à 6, dans lequel le boîtier (131) comporte un trottoir extérieur (135) qui borde à l'avant la paroi latérale (132) et dont une face arrière (136) est prévue pour s'appuyer contre le bord avant (115) de ladite boîte électrique (110) et dans lequel lesdits moyens de blocage angulaire sont situés sur ladite face arrière (136) du trottoir extérieur (135).

8. Module d'appareillage électrique (130) selon l'une des revendications 4 à 6, dans lequel ledit organe d'accrochage (137A) est porté par une patte flexible (137B), dans lequel ladite patte flexible (137B) comporte un retour (137E) dont une face arrière (137F) est prévue pour s'appuyer contre le bord avant (115) de ladite boîte électrique (110), et dans lequel lesdits moyens de blocage angulaire sont exclusivement situés sur la face arrière (137F) du retour (137E) de la patte flexible (137B).

9. Module d'appareillage électrique (130) selon l'une des revendications 4 à 6, dans lequel lesdits moyens de blocage angulaire (136B) sont situés sur une paroi arrière (133) dudit boîtier (131).

10. Module d'appareillage électrique (130) selon l'une des revendications précédentes, dans lequel la paroi avant (134) du boîtier (131) comprend une fenêtre d'accès audit espace intérieur qui est fermée par un enjoliveur (141) du mécanisme électrique (140).

11. Module d'appareillage électrique (130) selon l'une des revendications précédentes, dans lequel le boîtier (131) comporte des cloisons disposées dans ledit espace intérieur, qui viennent de formation avec une paroi arrière (133) dudit boîtier (131) et/ou avec la paroi latérale (132) et/ou avec la paroi avant (134) et qui délimitent un logement d'accueil et de blocage d'une borne de connexion électrique du mécanisme électrique (140) au réseau électrique local.

12. Module d'appareillage électrique (130) selon l'une des revendications précédentes, dans lequel le boîtier (131) comporte un trottoir extérieur (135) qui borde à l'avant la paroi latérale (132) et dont une face arrière (136) est inclinée vers l'extérieur.

13. Appareillage électrique (100) à encastrer dans une cavité (2) pratiquée dans une paroi (1), comportant :
- une boîte électrique (110) à encastrer dans une cavité (2) pratiquée dans une paroi (1), comportant :
- une paroi latérale (112) qui est ouverte vers l'avant selon un axe principal (A1) et qui définit intérieurement un volume d'accueil d'un module d'appareillage électrique (130) tel que défini dans l'une des revendications précédentes,
- des moyens de retenue (115, 117) de ladite paroi latérale (112) dans ladite cavité (2), et
- des moyens de blocage (119A) dudit module d'appareillage électrique (130) dans ledit volume d'accueil,
dans lequel lesdits moyens de blocage comportent, en creux dans la face interne de ladite paroi latérale (112), une face de butée (119A) qui s'étend orthogonalement à l'axe principal (A1), qui est tournée vers l'arrière et à laquelle sont adaptés à s'accrocher des moyens d'encliquetage (137) dudit module d'appareillage électrique (130), et
dans lequel il est prévu également un module d'appareillage électrique (130) selon l'une des revendications 1 à 12, dont ledit organe d'accrochage (137A) est adapté à s'accrocher à la face de butée (119A) qui est prévue en correspondance dans la face interne de ladite paroi latérale (112) et qui appartient auxdits moyens de blocage (119A).

14. Appareillage électrique (100) selon la revendication 13, dans laquelle ladite paroi latérale (112) présente au moins une fenêtre (119) allongée selon un axe orthogonal audit axe principal (A1), dont le bord avant (119A) forme ladite face de butée.

15. Appareillage électrique (100) selon la revendication 13, dans laquelle ladite paroi latérale présente, en creux dans une partie de l'épaisseur de sa face interne, une rainure allongée selon un axe orthogonal audit axe principal, dont le bord avant forme ladite face de butée.

16. Appareillage électrique (100) selon l'une des revendications 13 à 15, dans laquelle, la paroi latérale (112) étant sensiblement de révolution autour d'un axe principal (A1), il est prévu des moyens de blocage angulaire du module d'appareillage électrique (130) dans ledit volume d'accueil autour de l'axe principal (A1).

17. Appareillage électrique (100) selon la revendication 16, dans laquelle lesdits moyens de blocage angulaire comportent au moins deux crans (116; 118B) distincts situés sur un même cercle centré sur ledit axe principal (A1).

18. Appareillage électrique (100) selon la revendication 16, dans laquelle lesdits moyens de blocage angulaire comportent une couche compressible (116A) qui s'étend sur au moins un arc de cercle centré sur ledit axe principal (A1).

19. Appareillage électrique (100) selon l'une des revendications 16 à 18, dans laquelle il est prévu un trottoir extérieur (115) qui borde à l'avant la paroi latérale (112) et dans laquelle lesdits moyens de blocage angulaire sont situés sur la face avant (116) du trottoir extérieur (115).

20. Appareillage électrique (100) selon l'une des revendications 16 à 18, dans laquelle la paroi latérale (112) est fermée à l'arrière par une paroi de fond (113) et dans laquelle lesdits moyens de blocage angulaire sont situés à l'extrémité avant (118B) de pattes (118A) qui s'élèvent en saillie de la paroi de fond (113) et/ou le long de la paroi latérale (112).

21. Procédé de remplacement d'un ancien module d'appareillage électrique (130) selon l'une des revendications 1 à 12 par un nouveau module d'appareillage électrique selon l'une des revendications 1 à 12, ledit ancien module d'appareillage électrique (130) étant initialement bloqué dans une boîte électrique (110), selon lequel :
a) on manœuvre les moyens de manœuvre (137C) dudit ancien module d'appareillage électrique (130) pour ramener chaque organe d'accrochage (137A) en position rentrée,
b) on extrait ledit ancien module d'appareillage électrique (130) hors de ladite boîte électrique (110), et
c) on engage ledit nouveau module d'appareillage électrique dans ladite boîte électrique (110).

22. Procédé de remplacement selon la revendication précédente, dans lequel ladite étape a) est opérée manuellement, sans outil.

23. Procédé de remplacement selon l'une des revendications 21 et 22, dans lequel ladite étape c) est opérée sans manœuvrer les moyens de manœuvre du nouveau module d'appareillage électrique.

## Patentansprüche

1. Modul für eine elektrische Ausrüstung (130), das in eine elektrische Verdrahtungsdose (110) einzusetzen ist, wobei die elektrische Verdrahtungsdose (110) von dem Typ ist, der eine Seitenwand (112) aufweist, die nach vorne offen ist und die im Inneren ein Volumen zum Aufnehmen eines Moduls für eine elektrische Ausrüstung (130) definiert, wobei das Modul für eine elektrische Ausrüstung (130)
- ein Gehäuse (131) aus isolierendem Material, das eine Seitenwand (132) aufweist, die vorne durch eine Vorderwand (134) geschlossen ist, um einen Innenraum zum Aufnehmen eines elektrischen Mechanismus (140) abzugrenzen,
- Einrastmittel (137), die dazu ausgelegt sind, an einer Anschlagsfläche (119A) einzurasten, die in der Seitenwand (112) der elektrischen Verdrahtungsdose (110) als Mulde vorgesehen ist, die wenigstens ein Einrastorgan (137A) aufweisen, das von einer flexiblen Lasche (137B) getragen wird, die sich in Verlängerung der Seitenwand (132) des Gehäuses (131) befindet und die zwischen einer eingefahrenen Stellung, in der sie das Einsetzen des Gehäuses (131) in die elektrische Verdrahtungsdose (110) nicht behindert, und einer ausgefahrenen Stellung, in der sie dazu ausgelegt ist, direkt an der Anschlagsfläche (119A) einzurasten, und
- Mittel (137C) zum Betätigen der Einrastmittel (137), die durch eine in der Vorderwand (134) vorgesehene Zugangsöffnung (139) von vorne zugänglich sind und die einen Hebel (137C) aufweisen, der an der flexiblen Lasche (137B) angebracht ist, um das Einrastorgan (137A) in die eingefahrene Stellung zu bringen,
aufweist,
**dadurch gekennzeichnet, daß** die Vorderwand (134) des Gehäuses (131) Mittel (138) zum Befestigen einer Dekorationsplatte aufweist.

2. Modul für eine elektrische Ausrüstung (130) gemäß dem vorangehenden Anspruch, bei dem die flexible Lasche (137B) aus der Seitenwand (132) des Gehäuses (131) so herausgeschnitten ist, daß das Einrastorgan (137A) im Ruhezustand in ausgefahrener Stellung ist.

3. Modul für eine elektrische Ausrüstung (130) gemäß einem der vorangehenden Ansprüche, bei dem wenigstens zwei Einrastorgane (137A) vorgesehen sind, die gleichmäßig um das Gehäuse (131) herum verteilt sind.

4. Modul für eine elektrische Ausrüstung (130) gemäß einem der vorangehenden Ansprüche, bei dem die Seitenwand (132) des Gehäuses (131) im Wesentlichen rund um eine Hauptachse (A1) ist und Mittel zum winkelmäßigen Blockieren des Gehäuses (131) in der elektrischen Verdrahtungsdose (110) um die Hauptachse (A1) vorgesehen sind.

5. Modul für eine elektrische Ausrüstung (130) gemäß Anspruch 4, bei dem die Mittel zum winkelmäßigen Blockieren wenigstens zwei getrennte Einkerbungen (136; 137F) aufweisen, die auf einem selben, auf die Hauptachse (A1) zentrierten Kreis liegen.

6. Modul für eine elektrische Ausrüstung (130) gemäß Anspruch 4, bei dem die Mittel zum winkelmäßigen Blockieren eine komprimierbare Schicht aufweisen, die sich wenigstens über einen auf die Hauptachse (A1) zentrierten Kreisbogen erstreckt.

7. Modul für eine elektrische Ausrüstung (130) gemäß einem der Ansprüche 4 bis 6, bei dem das Gehäuse (131) einen äußeren Umlauf (135) aufweist, der vorne die Seitenwand (132) umgibt und von dem eine Rückseite (136) dafür vorgesehen ist, sich am Vorderrand (115) der elektrischen Verdrahtungsdose (110) abzustützen und bei dem sich die Mittel zum winkelmäßigen Blockieren auf der Rückseite (136) des äußeren Umlaufs (135) befinden.

8. Modul für eine elektrische Ausrüstung (130) gemäß einem der Ansprüche 4 bis 6, bei dem das Einrastorgan (137A) von einer flexiblen Lasche (137B) getragen wird, bei dem die flexible Lasche (137B) eine Rückführung (137E) aufweist, von der eine Rückseite (137F) dafür vorgesehen ist, sich am vorderen Rand (115) der elektrischen Verdrahtungsdose (110) abzustützen, und bei dem sich die Mittel zum winkelmäßigen Blockieren ausschließlich auf der Rückseite (137F) der Rückführung (137E) der flexiblen Lasche (137B) befinden.

9. Modul für eine elektrische Ausrüstung (130) gemäß einem der Ansprüche 4 bis 6, bei dem sich die Mittel (136B) zum winkelmäßigen Blockieren auf einer Rückwand (133) des Gehäuses (131) befinden.

10. Modul für eine elektrische Ausrüstung (130) gemäß einem der vorangehenden Ansprüche, bei dem die Vorderwand (134) des Gehäuses (131) ein Fenster für den Zugang zum Innenraum aufweist, das durch eine Zierkappe (141) des elektrischen Mechanismus (140) verdeckt ist.

11. Modul für eine elektrische Ausrüstung (130) gemäß einem der vorangehenden Ansprüche, bei dem das Gehäuse (131) in dem Innenraum angeordnete Wände aufweist, die mit einer Rückwand (133) des Gehäuses (131) und/oder mit der Seitenwand (132) und/oder mit der Vorderwand (134) einstückig gebildet sind und die einen Raum zum Aufnehmen und Blockieren einer Klemme für den elektrischen Anschluß des elektrischen Mechanismus (140) an das örtliche Stromnetz umgrenzen.

12. Modul für eine elektrische Ausrüstung (130) gemäß einem der vorangehenden Ansprüche, bei dem das Gehäuse (131) einen äußeren Umlauf (135) aufweist, der vorne die Seitenwand (132) umgibt und von dem eine Rückseite (136) nach außen geneigt ist.

13. Elektrische Ausrüstung (100), die in eine in einer Wand (1) ausgebildeten Vertiefung (2) einzusetzen ist, mit
- einer in eine in einer Wand (1) gebildeten Vertiefung (2) einzusetzenden elektrischen Verdrahtungsdose (110), die
- eine Seitenwand (112), die nach vorne entlang einer Hauptachse (A1) offen ist und im Inneren ein Volumen zum Aufnehmen eines Moduls für eine elektrische Ausrüstung (130), wie es in einem der vorangehenden Ansprüche definiert ist, definiert,
- Mittel (115, 117) zum Zurückhalten der Seitenwand (112) in der Vertiefung (2) und
- Mittel (119A) zum Blockieren des Moduls für eine elektrische Ausrüstung (130) in dem Aufnahmevolumen
aufweist,
wobei die Blockiermittel in der Innenseite der Seitenwand (112) als Mulde eine Anschlagsfläche (119A) aufweisen, die sich senkrecht zur Hauptachse (A1) erstreckt, die nach hinten gerichtet ist und an der angepaßte Einrastmittel (137) des Moduls für eine elektrische Ausrüstung (130) einrasten, und
wobei ebenfalls ein Modul für eine elektrische Ausrüstung (130) gemäß einem der Ansprüche 1 bis 12 vorgesehen ist, dessen Einrastorgan (137A) dazu ausgelegt ist, an der Anschlagsfläche (119A) einzurasten, die in der Innenseite der Seitenwand (112) entsprechend vorgesehen ist, und das zu den Blockiermitteln (119A) gehört.

14. Elektrische Ausrüstung (100) gemäß Anspruch 13, bei der die Seitenwand (112) wenigstens ein gemäß einer zur Hauptachse (A1) senkrechten Achse längliches Fenster (119) aufweist, dessen vorderer Rand (119A) die Anschlagsfläche bildet.

15. Elektrische Ausrüstung (100) gemäß Anspruch 13, bei der die Seitenwand als Vertiefung in einem Teil der Dicke ihrer Innenseite eine längliche Nut entlang einer zur Hauptachse rechtwinkligen Achse aufweist, deren vorderer Rand die Anschlagsfläche bildet.

16. Elektrische Ausrüstung (100) gemäß einem der Ansprüche 13 bis 15, bei der Mittel zum winkelmäßigen Blockieren des Moduls für eine elektrische Ausrüstung (130) vorgesehen sind, wobei die Seitenwand (112) im Wesentlichen rund um eine Hauptachse (A1) ist.

17. Elektrische Ausrüstung (100) gemäß Anspruch 16, bei der die Mittel zum winkelmäßigen Blockieren wenigstens zwei getrennte Einkerbungen (116; 118B) aufweisen, die auf einem selben, auf die Hauptachse (A1) zentrierten Kreis liegen.

18. Elektrische Ausrüstung (100) gemäß Anspruch 16, bei der die Mittel zum winkelmäßigen Blockieren eine komprimierbare Schicht (116A) aufweisen, die sich wenigstens über einen auf die Hauptachse (A1) zentrierten Kreisbogen erstreckt.

19. Elektrische Ausrüstung (100) gemäß einem der Ansprüche 16 bis 18, bei der ein äußerer Umlauf (115) vorgesehen ist, der vorne die Seitenwand (112) umgibt und bei dem sich die Mittel zum winkelmäßigen Blockieren auf der Vorderseite (116) des Umlaufs (115) befinden.

20. Elektrische Ausrüstung (100) gemäß einem der Ansprüche 16 bis 18, bei der die Seitenwand (112) hinten durch eine Bodenwand (113) geschlossen ist und bei der sich die Mittel zum winkelmäßigen Blockieren am vorderen Ende (118B) von Laschen (118A), die sich von der Bodenwand (113) abstehend und/oder entlang der Seitenwand (112) erheben.

21. Verfahren zum Austauschen eines alten elektrischen Ausrüstungsmoduls (130) gemäß einem der Ansprüche 1 bis 12 gegen ein neues elektrisches Ausrüstungsmodul (130) gemäß einem der Ansprüche 1 bis 12, wobei das alte elektrische Ausrüstungsmodul (130) ursprünglich in einer elektrischen Verdrahtungsdose (110) blockiert ist, bei dem
a) man die Betätigungsmittel (137C) des alten Moduls für eine elektrische Ausrüstung (130) betätigt, um jedes Einrastorgan (137A) in die eingefahrene Stellung zu bringen,
b) man das alte Modul für eine elektrische Ausrüstung (130) aus der elektrischen Verdrahtungsdose (110) herausholt und
c) man das neue Modul für eine elektrische Ausrüstung (130) in die elektrische Verdrahtungsdose (110) einsetzt.

22. Verfahren zum Austauschen gemäß dem vorangehenden Anspruch, bei dem der Schritt a) von Hand ohne Werkzeug ausgeführt wird.

23. Verfahren zum Austauschen gemäß einem der Ansprüche 21 und 22, bei dem der Schritt c) ohne Betätigung der Betätigungsmittel des neuen Moduls für eine elektrische Ausrüstung ausgeführt wird.

## Claims

1. An electrical-accessory module (130) for engaging in an electrical box (110), said electrical box (110) being of the kind comprising a side wall (112) that is open towards the front and that internally defines a reception volume for receiving an electrical-accessory module (130), said electrical-accessory module (130) including:
• a casing (131) that is made of insulating material, and that comprises a side wall (132) that is closed at the front by a front wall (134) for defining an inside space for receiving an electrical mechanism (140),
• snap-fastener means (137) that are adapted to catch an abutment face (119A) set back into the side wall (112)of the electrical box (110), which snap-fastener means include at least one catch member (137A) that is carried by a flexible tab (137B) situated flush with the side wall (132) of the casing (131), and that is movable between a retracted position in which it does not hinder the insertion of the casing (131) into said electrical box (110), and an extended position in which it is adapted to catch directly onto said abutment face (119A), and
• release means (137C) for releasing the snap-fastener means (137), which release means are accessible via the front, through an access opening (139) provided in said front wall (134) and comprises a lever (137C) linked to the flexible tab (137B) so as to return said catch member (137A) into its retracted position,
**characterized in that** the front wall (134) of the casing (131) includes securing means (138) for securing a finishing plate.

2. An electrical-accessory module (130) according to the preceding claim, wherein said flexible tab (137B) is cut out in the side wall (132) of the casing (131) in such a manner that, at rest, said catch member (137A) is in its extended position.

3. An electrical-accessory module (130) according to any preceding claim, wherein at least two catch members (137A) are provided that are regularly distributed around the casing (131).

4. An electrical-accessory module (130) according to any preceding claim, wherein, since the side wall (132) of the casing (131) is substantially circular about a main axis (A1), angular blocking means are provided for blocking the casing (131) in the electrical box (110), about the main axis (A1).

5. An electrical-accessory module (130) according to claim 4, wherein said angular blocking means comprise at least two distinct serrations (136; 137F) that are situated on a single circle centered on said main axis (A1).

6. An electrical-accessory module (130) according to claim 4, wherein said angular blocking means comprise a compressible layer that extends over at least one circular arc centered on said main axis (A1).

7. An electrical-accessory module (130) according to any one of claims 4 to 6, wherein the casing (131) includes an outer collar (135) that borders the side wall (132) at the front, and that has a rear face (136) that is designed to bear against the front face (115) of said electrical box (110), and wherein said angular blocking means are situated on said rear face (136) of the outer collar (135).

8. An electrical-accessory module (130) according to any one of claims 4 to 6, wherein said catch member (137A) is carried by a flexible tab (137B), wherein said flexible tab (137B) includes a rim (137E) having a rear face (137F) that is designed to bear against the front edge (115) of said electrical box (110), and wherein said angular blocking means are exclusively situated on the rear face (137F) of the rim (137E) of the flexible tab (137B).

9. An electrical-accessory module (130) according to any one of claims 4 to 6, wherein said angular blocking means (136B) are situated on a rear wall (133) of said casing (131) .

10. An electrical-accessory module (130) according to any preceding claim, wherein the front wall (134) of the casing (131) includes an access window for accessing said inside space that is closed by trim (141) of the electrical mechanism (140).

11. An electrical-accessory module (130) according to any preceding claim, wherein the casing (131) includes partitions that are arranged in said inside space, which partitions are formed integrally with a rear wall (133) of said casing (131) and/or with the side wall (132) and/or with the front wall (134), and define a housing for receiving and blocking an electrical-connection terminal for connecting the electrical mechanism (140) to the local electricity network.

12. An electrical-accessory module (130) according to any preceding claim, wherein the casing (131) includes an outer collar (135) that borders the side wall (132) at the front, and that has a rear face (136) that slopes outwards.

13. An electrical accessory (100) for flush mounting in a cavity (2) formed in a wall (1), said electrical accessory comprising:
• an electrical box (110) for flush mounting in a cavity (2) formed in a wall (1), comprising:
- a side wall (112) that is open towards the front along a main axis (A1), and that internally defines a reception volume for receiving an electrical-accessory module (130) as claimed in one of the previous claims;
- holder means (115, 117) for holding said side wall (112) in said cavity (2); and
- blocking means (119A) for blocking said electrical-accessory module (130) in said reception volume;
Wherein said blocking means comprise, set back into the inside face of said side wall (112), an abutment face (119A) that faces towards the rear, and onto which snap-fastener means (137) of said electrical-accessory module (130) are adapted to catch, and
Wherein an electrical-accessory module (130) according to any one of claims 1 to 12 is also provided, the catch member (137A) of which is adapted to catch onto a corresponding abutment face (119A) that is provided in the inside face of said side wall (112) and that belongs to said blocking means (119A).

14. An electrical box (110) according to claim 13, wherein said side wall (112) presents at least one slot (119) that is elongate along an axis that is orthogonal to said main axis (A1), having a front edge (119A) that forms said abutment face.

15. An electrical box (110) according to claim 13, wherein, set back into a fraction of the thickness of its inside face, said side wall presents a groove that is elongate along an axis that is orthogonal to said main axis, having a front edge that forms said abutment face.

16. An electrical box (110) according to any one of claims 13 to 15, wherein, since the side wall (112) is substantially circular about a main axis (A1), angular blocking means are provided for blocking the electrical-accessory module (130) in said reception volume, about the main axis (A1).

17. An electrical box (110) according to claim 16, wherein said angular blocking means comprise at least two distinct serrations (116; 118B) that are situated on a single circle centered on said main axis (A1).

18. An electrical box (110) according to claim 16, wherein said angular blocking means comprise a compressible layer (116A) that extends over at least one circular arc centered on said main axis (A1).

19. An electrical box (110) according to any one of claims 16 to 18, wherein an outer collar (115) is provided that borders the side wall (112) at the front, and wherein said angular blocking means are situated on the front face (116) of the outer collar (115).

20. An electrical box (110) according to any one of claims 16 to 18, wherein the side wall (112) is closed at the rear by a rear wall (113), and wherein said angular blocking means are situated at the front end (118B) of tabs (118A) that project from the rear wall (113) and/or along the side wall (112).

21. A replacement method for replacing an old electrical-accessory module (130) according to any one of claims 1 to 12 with a new electrical-accessory module according to any one of claims 1 to 12, said old electrical-accessory module (130) initially being blocked in an electrical box (110), wherein:
a) the release means (137C) of said old electrical-accessory module (130) are moved so as to return each catch member (137A) into its retracted position;
b) said old electrical-accessory module (130) is extracted from said electrical box (110); and
c) said new electrical-accessory module is engaged in said electrical box (110).

22. A replacement method according to the preceding claim, wherein said step a) is performed manually, without any tools.

23. A replacement method according to claim 21 and 22, wherein said step c) is performed without moving the release means of the new electrical-accessory module.
